# EUROPÄISCHE PATENTSCHRIFT

(11) **EP 2 023 702 B1**
(45) Veröffentlichungstag und Bekanntmachung des Hinweises auf die Patenterteilung: **04.01.2012**
(21) Anmeldenummer: 08104522.1
(22) Anmeldetag: 24.06.2008
(51) Int. Cl.: H05K 5/00

(54) **Gehäuse für eine Leiterplatte und Leiterplatten-Baugruppe mit Toleranzausgleich**
Casing for a circuit board and circuit board component with tolerance compensation
Boîtier pour une plaquette et composants de plaquettes dotés d'une égalisation de la tolérance

(30) Priorität: 07.08.2007 DE 102007037221
(43) Veröffentlichungstag der Anmeldung: 11.02.2009
(73) Patentinhaber: ROBERT BOSCH GMBH, 70442 Stuttgart (DE)
(72) Erfinder: Lippok, Ralf, 71522 Backnang (DE)

(56) Entgegenhaltungen:
- EP-A- 1 596 642
- WO-A-01/78197
- DE-A1- 3 903 615
- FR-A- 2 840 735

## Beschreibung

Die Erfindung betrifft ein Gehäuse für eine Leiterplatte gemäß dem Oberbegriff des Anspruchs 1 und eine Leiterplatten-Baugruppe gemäß dem Oberbegriff des Anspruchs 8.

### Stand der Technik

Dort, wo elektronische Bauteile tragende Leiterplatten an feuchten, staubbelasteten und/oder für Menschen zugänglichen Stellen von Geräten, Maschinen oder Einrichtungen eingesetzt werden, sind die Leiterplatten in der Regel von einem aus Kunststoff hergestellten Gehäuse umgeben, das als Schutz vor Feuchtigkeit, Verschmutzung und/oder Berührung der Leiterplatte dient. Die Gehäuse bestehen häufig aus zwei Teilen, einem Gehäuseoberteil und einem Gehäuseunterteil, von denen bei Gehäusen der eingangs genannten Art eines, zumeist das Gehäuseoberteil, bereits mit integrierten Steckverbindern versehen sein kann, um die Montage der Leiterplatte im Gehäuse und das Anschließen der fertig montierten Leiterplatten-Baugruppe an Steckverbinder von Kabeln oder andere externe Steckverbinder zu erleichtern und damit den Herstellungs- und Montageaufwand zu verringern. Die in das Gehäuseoberteil integrierten Steckverbinder weisen einerseits ins Innere des Gehäuses überstehende Steckverbinder-Pins auf, die sich bei der Montage der Leiterplatte am Gehäuseteil in komplementäre Durchkontaktierungen der Leiterplatte einführen lassen, und gestatten es andererseits beim Einbau der Leiterplatten-Baugruppe in Geräte, Maschinen oder Einrichtungen, eine schnelle und einfache Verbindung mit den externen Steckverbindern herzustellen.

Dort, wo die Steckverbinder-Pins als Lötpins ausgebildet sind und in Durchstecktechnik in die Durchkontaktierungen der Leiterplatte eingeführt werden, bevor sie zur Kontaktierung mit der Leiterplatte verlötet werden, wird die Leiterplatte beim Einführen der Lötpins in die Durchkontaktierungen zweckmäßig mit dem Gehäuseteil verrastet. Dadurch wird für einen sicheren Zusammenhalt der Leiterplatte und des Gehäuseteils beim Verlöten der Kontaktstellen gesorgt, das zum Beispiel mittels eines Schöpflötverfahrens oder eines anderen geeigneten Lötverfahrens vorgenommen werden kann.

Alternativ können die Steckverbinder-Pins auch als Einpress-Pins ausgebildet sein, die mit Presspassung in die Durchkontaktierungen der Leiterplatte eingeführt werden, um gleichzeitig für eine ordnungsgemäße Kontaktierung zwischen den Steckverbindern und der Leiterplatte sowie für eine sichere mechanische Befestigung der Leiterplatte im Gehäuseteil zu sorgen.

Dort, wo einerseits großformatige Leiterplatten benötigt werden und wo andererseits aus Konstruktionsgründen verhältnismäßig große Abstände zwischen zwei Steckerleisten vorgesehen werden müssen, können allerdings infolge unterschiedlicher thermischer Ausdehnungskoeffizienten der Leiterplatte und des Gehäuseteils bei der Montage Probleme hinsichtlich der zulässigen Toleranzen bei der passgenauen Übereinstimmung der Steckverbinder-Pins und der Durchkontaktierungen und damit hinsichtlich der Robustheit der Montage gegen mögliche Abweichungen auftreten. Darüber hinaus kann insbesondere im Fall von verlöteten Steckverbinder-Pins im späteren Betrieb der Leiterplatten-Baugruppe nicht immer eine ausreichende Temperaturwechselfestigkeit der Steckverbinder-Pins an den Kontaktstellen gewährleistet werden.

Aus EP 1596642 A2 sind Gehäuse mit einer Leiterplattenbaugruppe zur Ansteuerung eines Haushaltsgerätes bekannt. Ein als Gehäusedeckel ausgebildete Gehäuseteil weist zwei flexibel gehaltene, durch einen Spalt getrennte Steckbereiche in Form einer Steckbereichsleiste auf, die bei einer Erwärmung des Gehäuses einerseits sowie der Leiterplatte andererseits eine Bewegung zusammen mit den Kontaktierungen der Leiterplatte vollziehen. Die flexible Halterung der Steckbereich sind als dünne am Gehäusedeckel angeformte Rippen ausgebildet. Diese Rippen lassen eine parallelogrammartige Verschiebung der Steckbereichsleiste zu. Nachteilig sind Probleme bei der Montage durch zulässigen Toleranzen bei der passgenauen Übereinstimmung der Steckverbinder-Pins und der Durchkontaktierungen und damit hinsichtlich der Robustheit der Montage gegen mögliche Abweichungen.

Ebenso sind in WO 01/78197 in Gehäusen integrierte Steckeranschlüsse beschrieben, welche einen Toleranzausgleich zu am Gehäuse angebundenen elektrischen Baugruppen zeigen.

Ausgehend hiervon liegt der Erfindung die Aufgabe zugrunde, ein Gehäuse für eine Leiterplatte und eine Leiterplatten-Baugruppe der eingangs genannten Art dahingehend zu verbessern, dass zum einen eine größere Robustheit der Montage und zum anderen eine ausreichende Temperaturwechselfestigkeit der Steckverbinder-Pins im Betrieb sichergestellt werden kann.

### Offenbarung der Erfindung

Diese Aufgabe wird erfindungsgemäß durch ein Gehäuse mit den Merkmalen des Anspruchs 1 gelöst. Hierbes umfasst das Gehäuseteil zwei in Bezug zueinander begrenzt bewegliche Teile, von denen jeder Teil einen der beiden Steckverbinder trägt. Durch die begrenzte Beweglichkeit der beiden Teile werden die beiden Steckverbinder voneinander entkoppelt, so dass ein Ausgleich unterschiedlicher Wärmedehnungen von Leiterplatte und Gehäuseteil möglich ist.

Um einerseits eine ausreichende Beweglichkeit zu gewährleisten, andererseits jedoch zu verhindern, dass sich die beiden Teile in Bezug zueinander übermäßig bewegen können, sind die beiden Teile durch einen die Bewegung ermöglichenden Spalt voneinander getrennt. Erfindungsgemäß ist vorgesehen, dass die beiden Teile durch mindestens eine verformbare Materialbrücke verbunden sind, die den Spalt zwischen den beiden Teilen überspannt.

Die Materialbrücke kann zweckmäßig eine Mehrzahl von einzelnen, im Abstand voneinander angeordneten Verbindungsstegen umfassen, welche die beiden Teile miteinander verbinden, wodurch es ermöglicht wird, die beiden Teile zusammen mit den Verbindungsstegen durch Spritzgießen einstückig aus ein und demselben Kunststoffmaterial herzustellen.

Um eine seitliche Bewegung der beiden Teile zu vermeiden, sind die Verbindungsstege vorzugsweise so angeordnet, dass sie den Spalt schräg zur Spaltrichtung überbrücken oder mäanderförmig verlaufen, wobei benachbarte Gruppen von Stegen oder benachbarte Stege zweckmäßig symmetrisch zu einer Längsmittelachse des Gehäuseteils bzw. einer zur Längsmittelachse parallelen Geraden ausgerichtet sind, so dass sie Seitwärtsbewegungen in beiden Richtungen denselben Widerstand entgegensetzen.

Dieselbe Wirkung kann auch dadurch erzielt werden, dass die beiden Teile mit zusammenwirkenden Linearführungen versehen sind, die eine begrenzte translatorische Bewegung der beiden Teile zur Annäherung bzw. Auseinanderbewegung der darauf angeordneten Steckverbinder zulässt, jedoch Bewegungen in anderen Richtungen ausschließt.

Alternativ können die beiden Teile auch aus einem im Verhältnis starren Kunststoffmaterial bestehen, während die Materialbrücke aus einem zweckmäßig an den beiden Teilen angeformten nachgiebigen Elastomermaterial besteht. Dadurch müssen zwar zur Herstellung des Gehäuseteils verschiedene Materialien eingesetzt werden, jedoch kann auf diese Weise eine bessere Abdichtung gegen Schmutz und Feuchtigkeit gewährleistet werden.

Eine weitere Alternative sieht vor, dass sich die beiden Teile zwischen den Steckverbindern überlappen, wodurch ebenfalls ein Eindringen von Schmutz oder Feuchtigkeit durch den Spalt ins Innere des Gehäuses verhindert werden kann.

### Kurze Beschreibung der Zeichnungen

Im folgenden wird die Erfindung anhand einiger in der Zeichnung dargestellter Ausführungsbeispiele näher erläutert. Es zeigen:
Fig. 1 eine schematische auseinandergezogene perspektivische Ansicht einer Leiterplatte und eines geteilten Gehäuseoberteils eines zur Aufnahme der Leiterplatte dienenden Gehäuses;
Fig. 2 eine vergrößerte Oberseitenansicht des umrandeten Bereichs in Fig. 1;
Fig. 3 eine Ansicht entsprechend Fig. 2, jedoch von einer anderen Ausführungsform des Gehäuseoberteils;
Fig. 4 eine vergrößerte Seitenansicht einer noch anderen Ausführungsform des Gehäuseoberteils;
Fig. 5 eine vergrößerte Schnittansicht einer noch weiteren Ausführungsform des Gehäuseoberteils.

### Ausführungsformen der Erfindung

Die in der Zeichnung nur teilweise dargestellte Leiterplatten-Baugruppe 2 für eine Steuer- oder Regeleinrichtung besteht im Wesentlichen aus einer Leiterplatte 4 und einem die Leiterplatte 4 umgebenden Gehäuse, von dem jedoch in der Zeichnung nur ein Gehäuseoberteil 6 in umgedrehtem Zustand, das heißt mit der Unterseite 8 nach oben weisend, dargestellt ist.

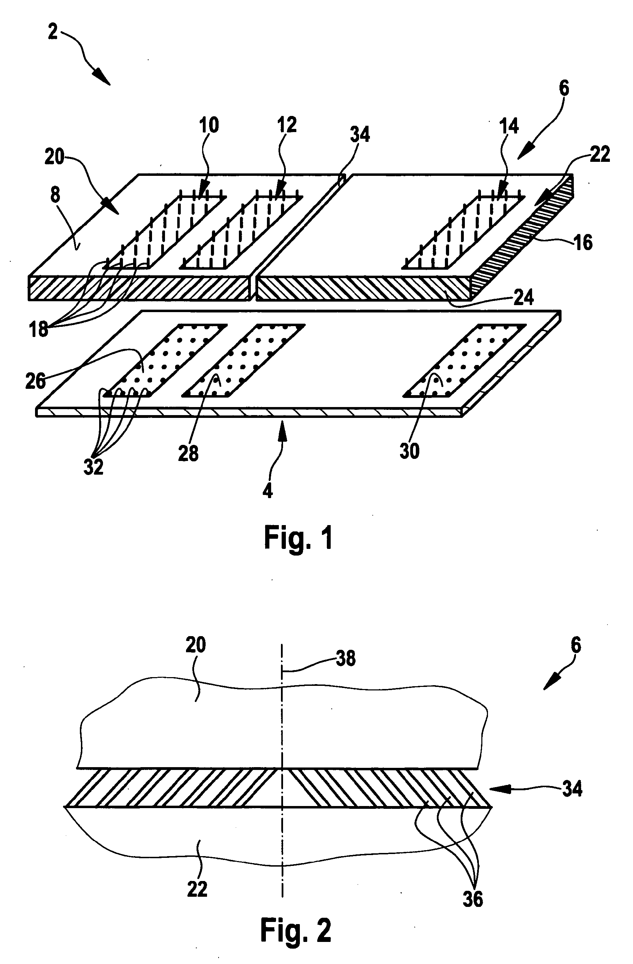

Wie in Fig. 1 dargestellt, ist das im Umriss rechteckige aus Kunststoff hergestellte Gehäuseoberteil 6 mit insgesamt drei integrierten Steckverbindern in Form von Steckerleisten 10, 12, 14 versehen, die jeweils parallel zueinander und zu den Schmalseitenrändern 16 des Gehäuseoberteils 6 ausgerichtet sind. Die Steckerleisten 10, 12, 14 sind in den Kunststoff des Gehäuseoberteils 6 eingeformt und weisen eine Mehrzahl von elektrischen Kontakten auf, die das Gehäuseoberteil 6 durchsetzen und in Form von parallel zueinander ausgerichteten Steckverbinder-Pins 18 über die ebene Innenseite des Gehäuseoberteils 6 überstehen, so dass sie bei dem in Fig. 1 in umgedrehtem Zustand dargestellten Gehäuseoberteil 6 nach oben weisen. Bei dem beispielhaften Gehäuseoberteil 6 in Fig. 1 sind zwei der Steckerleisten 10 und 12 in einem relativ geringen Abstand voneinander auf einer Hälfte 20 des Gehäuseoberteils 6 angeordnet, während die dritte Steckerleiste 14 in einem größeren Abstand von den beiden Steckerleisten 10, 12 auf der anderen Hälfte 22 des Gehäuseoberteils 6 angeordnet ist. Jede der Steckerleisten 10, 12, 14 weist vier zu den Längsseitenrändern 24 des Gehäuseoberteils 6 parallele Reihen von je vier Kontakten bzw. Steckverbinder-Pins 18 auf, jedoch sind auch beliebige andere Anordnungen möglich. Auf der Außenseite (nicht sichtbar) des Gehäuseoberteils 6 können die Steckerleisten 10, 12, 14 als Stecker oder Steckerbuchsen für den Anschluss externer Steckerbuchsen bzw. Stecker von Kabeln oder dergleichen ausgebildet sein.

Das Gehäuseoberteil 6 ist auf seiner der Leiterplatte 4 zugewandten Unterseite zudem mit Rastmitteln (nicht dargestellt) versehen, mit denen sich bei der Montage der Leiterplatte 4 komplementäre Rastmittel (nicht dargestellt) auf der Oberseite oder am Rand der Leiterplatte 4 verrasten lassen, um die Leiterplatte 4 in einem vorgegebenen Abstand und in paralleler Ausrichtung zum Gehäuseoberteil 6 zu halten.

Die Leiterplatte 4 wird in bekannter Weise aus einem elektrisch isolierenden Trägermaterial, zum Beispiel laminierten, mit Epoxidharz getränkten Glasfasermatten, und einer oder zwei Kupferschichten an der oder den Oberflächen hergestellt, aus denen dann die Leiterbahnen einer gewünschten Schaltung geätzt werden. Die Leiterplatte 4 weist auf ihrer Oberseite neben den Leiterbahnen drei Kontaktfelder 26, 28, 30 auf, deren Größe und Anordnung der Anordnung der Steckerleisten 10, 12, 14 im Gehäuseoberteil 6 entspricht. Die Leiterplatte 4 trägt darüber hinaus eine Mehrzahl von elektronischen Bauteilen, die für die Funktion der Steuer- oder Regeleinrichtung erforderlich sind und in an sich bekannter Weise auf der in Fig. 1 nicht sichtbaren Unterseite der Leiterplatte 4 montiert sind.

Jedes der drei Kontaktfelder 26, 28, 30 ist mit einer Mehrzahl von Durchkontaktierungen 32 versehen, deren Anzahl, Anordnung und Ausrichtung der Anzahl, Anordnung und Ausrichtung der über die benachbarte Innenseite des Gehäuseoberteils 6 überstehenden Steckverbinder-Pins 18 der Steckerleisten 10, 12, 14 entspricht.

Zur Montage der Leiterplatte 4 im Gehäuse wird die Leiterplatte 4 zuerst aus ihrer in Fig. 1 dargestellten Stellung umgedreht und dann auf die Innenseite des in Fig. 1 bereits in umgedrehtem Zustand dargestellten Gehäuseoberteils 6 gelegt. Dabei treten sämtliche Steckverbinder-Pins 18 durch eine jeweils zugehörige Durchkontaktierung 32 von einem der Kontaktfelder 26, 28, 30 der Leiterplatte 4 hindurch, während gleichzeitig die Rastmittel des Gehäuseoberteils 6 mit den komplementären Rastmitteln der Leiterplatte 4 in Rasteingriff treten, so dass bis zu einem anschließenden Verlöten der Steckverbinder-Pins 18 mit den Durchkontaktierungen 32 ein sicherer Zusammenhalt der Leiterplatte 4 und des Gehäuseoberteils 6 gewährleistet ist.

Das Verlöten der Steckverbinder-Pins 18 der Steckerleisten 10, 12, 14 in den Durchkontaktierungen 32 der Leiterplatte 4 zum Anschluss der elektrischen Kontakte der Steckerleisten 10, 12, 14 an die gedruckte Schaltung auf der Leiterplatte 4 kann zum Beispiel durch Schöpflöten, Selektivlöten, Tiegellöten oder einen vergleichbaren Prozess, wie Reflow-Löten im Durchsteck-Verfahren (Through Hole Reflow Soldering) erfolgen.

Um zu vermeiden, dass es bei der Montage der Leiterplatten-Baugruppe 2 aufgrund der relativ großen Abstände zwischen den Steckerleisten 10, 12 auf der einen Hälfte 20 des Gehäuseoberteils 6 einerseits und der Steckerleiste 14 auf der anderen Hälfte 22 des Gehäuseoberteils 6 andererseits bzw. zwischen den entsprechenden Kontaktfeldern 26, 28 bzw. 30 auf der Leiterplatte 4 sowie aufgrund unterschiedlicher thermischer Ausdehnungskoeffizienten des Materials des Gehäuseoberteils 6 und der Leiterplatte 4 zu einer mangelhaften Passgenauigkeit zwischen einem Teil der Steckverbinder-Pins 18 und jeweils zugehörigen Durchkontaktierungen 32 und damit zu Problemen mit der Robustheit der Montage kommt, und um zu vermeiden, dass es aus denselben Gründen im späteren Betrieb der Leiterplatten-Baugruppe 2 zu Problemen mit einer unzureichenden Temperaturwechselfestigkeit der Lötstellen zwischen den Steckverbinder-Pins 18 und den Durchkontaktierungen 32 kommt, sind die beiden, die Steckerleisten 10, 12 bzw. 14 tragenden Hälften 20 und 22 des Gehäuseoberteils 6 zumindest in einer zu den Längsseitenrändern 24 parallelen Richtung in Bezug zueinander begrenzt beweglich.

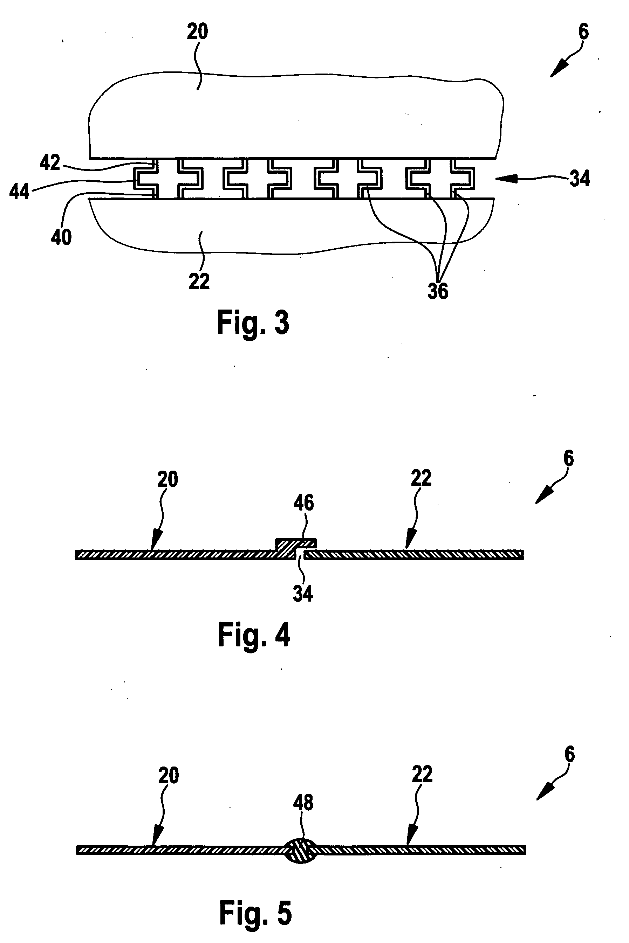

Bei den in Fig. 2 und 3 dargestellten Ausführungsformen wird die begrenzte Beweglichkeit der beiden Hälften 20, 22 des Gehäuseoberteils 6 in Bezug zueinander dadurch erreicht, dass die beiden Hälften 20, 22 durch einen parallel zu den Schmalseitenrändern 16 des Gehäuseoberteils 6 verlaufenden Spalt 34 getrennt sind, der von dünnen, elastisch verformbaren und im Abstand nebeneinander angeordneten Stegen 36 überbrückt wird. Die Stege 36 werden bei der Herstellung des Gehäuseoberteils 6 durch Spritzgießen zweckmäßig einstückig mit den beiden Hälften 20, 22 aus demselben Kunststoffmaterial gespritzt und gestatten für den Fall von unterschiedlichen Wärmedehnungen der Leiterplatte 4 und des Gehäuseoberteils 6 einen gewissen Ausgleich dieser Unterschiede.

Bei der in Fig. 2 dargestellten Ausführungsform verlaufen die Stege 36 geradlinig zwischen den beiden Hälften 20, 22, wobei sämtliche Stege 36 unter einem Winkel von etwa 45 Grad zu den Längsseitenrändern 24 des Gehäuseoberteils 6 geneigt sind und wobei die jeweils beiderseits einer Längsmittelachse 38 des Gehäuseoberteils 6 angeordneten und zueinander parallelen Stege 36 V-förmig konvergieren bzw. divergieren.

Bei der in Fig. 3 dargestellten Ausführungsform verlaufen die Stege 36 zwischen den beiden Hälften 20, 22 des Gehäuseoberteils 6 mäanderförmig, wobei ihre entgegengesetzten Endabschnitte 40, 42 jeweils parallel zur Längsmittelachse 38 des Gehäuseoberteils 6 mit dem benachbarten Begrenzungsrand des Spaltes 34 verbunden sind. Die zwischen den entgegengesetzten Endabschnitten 40, 42 angeordneten, die Endabschnitte 40, 42 verbindenden Mittelabschnitte 44 der Stege 36 sind U-förmig ausgebildet, wobei die Mittelabschnitte 44 benachbarter Stege 36 in Spaltlängsrichtung nach entgegengesetzten Seiten über die Endabschnitte 40, 42 überstehen.

Bei der in Fig. 4 dargestellten Ausführungsform sind die beiden Hälften 20, 22 des Gehäuseoberteils 6 als getrennte, nicht miteinander verbundene Teile ausgebildet, wobei eine der beiden Hälften 20 angrenzend an den Spalt 34 mit einer den Spalt 34 überbrückenden und die andere Hälfte 22 überlappenden Stufe 46 versehen ist.

Bei der in Fig. 5 dargestellten Ausführungsform sind die beiden durch Spritzgießen aus einem starren Kunststoffmaterial hergestellten Hälften 20, 22 des Gehäuseoberteils 6 entlang des Spaltes 34 zwischen den beiden Hälften 20, 22 durch ein elastisch nachgiebiges Elastomermaterial 48 verbunden, vorzugsweise ein thermoplastisches Elastomermaterial, das nach dem Spritzgießen der beiden Hälften 20, 22 in derselben Spritzgussform an die beiden Hälften 20, 22 angespritzt werden kann, wobei es den Spalt 34 ausfüllt und überbrückt.

## Patentansprüche

1. Gehäuse für eine Leiterplatte (4), bei dem ein Gehäuseteil (6) mit mindestens zwei in einem Abstand voneinander angeordneten integrierten Steckverbindern (10, 12 bzw. 14) versehen ist, wobei die Steckverbinder (10, 12 bzw. 14) jeweils mindestens einen nach innen in das Gehäuse überstehenden Steckverbinder-Pin (18) umfassen, der sich in eine zugehörige Durchkontaktierung (32) der Leiterplatte (4) einführen lässt, wobei das Gehäuseteil (6) zwei in Bezug zueinander begrenzt bewegliche Teile (20, 22) umfasst, von denen jeder einen der beiden Steckverbinder (10, 12 bzw. 14) trägt, und wobei die beiden Teile (20, 22) voneinander durch einen Spalt (34) getrennt sind, **dadurch gekennzeichnet, dass** die beiden Teile (20, 22) durch mindestens eine verformbare Materialbrücke (36, 48) verbunden sind, die den Spalt (34) zwischen den beiden Teilen (20, 22) überspannt oder mit zusammenwirkenden Linearführungen versehen sind, die eine begrenzte translatorische Bewegung der beiden Teile zur Annäherung bzw. Auseinanderbewegung der darauf angeordneten Steckverbinder zulässt, jedoch Bewegungen in anderen Richtungen ausschließt.

2. Gehäuse nach Anspruch 1, **dadurch gekennzeichnet, dass** die Materialbrücke eine Mehrzahl von einzelnen, im Abstand voneinander angeordneten Verbindungsstegen (36) umfasst, welche die beiden Teile (20, 22) miteinander verbinden.

3. Gehäuse nach Anspruch 2, **dadurch gekennzeichnet, dass** die Verbindungsstege (36) einstückig mit den beiden Teilen (20, 22) ausgebildet sind.

4. Gehäuse nach Anspruch 2 oder 3, **dadurch gekennzeichnet, dass** die Verbindungsstege (36) den Spalt (34) schräg zur Spaltrichtung oder mit einem mäanderförmigen Verlauf überbrücken, der einen U-förmigen Mittelabschnitt (44) zwischen zwei quer zur Längsrichtung des Spaltes (34) ausgerichteten, jeweils mit einem der Teile (20, 22) verbundenen Endabschnitten (40, 42) umfasst.

5. Gehäuse nach Anspruch 1, **dadurch gekennzeichnet, dass** die beiden Teile (20, 22) aus einem im Verhältnis starren Kunststoffmaterial bestehen, und dass die Materialbrücke (48) aus einem im Verhältnis nachgiebigen Elastomermaterial besteht.

6. Gehäuse nach Anspruch 5, **dadurch gekennzeichnet, dass** die Materialbrücke (48) an den beiden Teilen (20, 22) angeformt ist und den Spalt (34) verschließt.

7. Gehäuse nach Anspruch 1, **dadurch gekennzeichnet, dass** sich die beiden Teile (20, 22) zwischen den Steckverbindern (10, 12 bzw. 14) überlappen.

8. Leiterplatten-Baugruppe, umfassend eine Leiterplatte und ein die Leiterplatte umgebendes Gehäuse gemäß dem Anspruch 1.

## Claims

1. Housing for a printed circuit board (4), in which housing a housing part (6) is provided with at least two integrated plug connectors (10, 12 or 14) which are arranged at a distance from one another, with the plug connectors (10, 12 or 14) each comprising at least one plug connector pin (18) which projects inwards into the housing and can be inserted into an associated plated-through hole (32) in the printed circuit board (4), with the housing part (6) comprising two parts (20, 22) which can moved relative to one another to a limited extent and of which each is fitted with one of the two plug connectors (10, 12 or 14), and with the two parts (20, 22) being separated from one another by a gap (34), **characterized in that** the two parts (20, 22) are connected by at least one deformable material bridge (36, 48) which spans the gap (34) between the two parts (20, 22), or are provided with interacting linear guides which permit a limited translatory movement of the two parts in order for the plug connectors which are arranged on them to move toward or move away from one another, but prevent movements in other directions.

2. Housing according to Claim 1, **characterized in that** the material bridge comprises a plurality of individual connecting webs (36) which are arranged at a distance from one another and connect the two parts (20, 22) to one another.

3. Housing according to Claim 2, **characterized in that** the connecting webs (36) are integrally formed with the two parts (20, 22).

4. Housing according to Claim 2 or 3, **characterized in that** the connecting webs (36) bridge the gap (34) obliquely to the gap direction or with a meandering course which comprises a U-shaped central section (44) between two end sections (40, 42) which are oriented transverse to the longitudinal direction of the gap (34) and are each connected to one of the parts (20, 22).

5. Housing according to Claim 1, **characterized in that** the two parts (20, 22) are composed of a comparatively inflexible plastic material, and **in that** the material bridge (48) is composed of a relatively flexible elastomeric material.

6. Housing according to Claim 5, **characterized in that** the material bridge (48) is integrally formed on the two parts (20, 22) and closes the gap (34).

7. Housing according to Claim 1, **characterized in that** the two parts (20, 22) overlap between the plug connectors (10, 12 or 14).

8. Printed circuit board assembly comprising a printed circuit board and a housing according to Claim 1 which surrounds the printed circuit board.

## Revendications

1. Boîtier pour une carte de circuit imprimé (4), dans lequel une pièce de boîtier (6) est pourvue d'au moins deux connecteurs à fiches (10, 12 ou 14) intégrés et espacés entre eux, les connecteurs à fiches (10, 12 ou 14) comprenant chacun au moins une broche de connecteur à fiches (18) faisant saillie vers l'intérieur dans le boîtier et susceptible d'être introduite dans un trou métallisé (32) associé de la carte de circuit imprimé (4), la pièce de boîtier (6) comprenant deux parties (20, 22) aptes à effectuer un déplacement limité l'une par rapport à l'autre, parmi lesquelles chacune porte l'un des deux connecteurs à fiches (10, 12 ou 14), et les deux parties (20, 22) étant séparées l'une de l'autre par une fente (34), **caractérisé en ce que** les deux parties (20, 22) sont reliées par au moins un pont de matériau déformable (36, 48) enjambant la fente (34) entre les deux parties (20, 22) ou pourvues de guidages linéaires coopérant l'un avec l'autre, qui permettent un mouvement de translation limité des deux parties pour le rapprochement ou l'éloignement des connecteurs à fiches disposés dessus, mais excluent tout mouvement dans d'autres directions.

2. Boîtier selon la revendication 1, **caractérisé en ce que** le pont de matériau comprend une pluralité d'âmes de liaison (36) séparées et espacées les unes des autres, reliant les deux parties (20, 22) entre elles.

3. Boîtier selon la revendication 2, **caractérisé en ce que** les âmes de liaison (36) sont constituées d'une seule pièce avec les deux parties (20, 22).

4. Boîtier selon la revendication 2 ou 3, **caractérisé en ce que** les âmes de liaison (36) enjambent la fente (34) de façon oblique par rapport à la direction de la fente ou avec un parcours en forme de méandres comprenant une section centrale en forme de U (44) entre deux sections terminales (40, 42) reliées chacune à l'une des parties (20, 22) et orientées perpendiculairement au sens longitudinal de la fente (34).

5. Boîtier selon la revendication 1, **caractérisé en ce que** les deux parties (20, 22) sont constituées d'une matière plastique relativement rigide, et **en ce que** le pont de matériau (48) est constitué d'une matière élastomère relativement souple.

6. Boîtier selon la revendication 5, **caractérisé en ce que** le pont de matériau (48) est formé sur les deux parties (20, 22) et bouche la fente (34).

7. Boîtier selon la revendication 1, **caractérisé en ce que** les deux parties (20, 22) se chevauchent entre les connecteurs à fiches (10, 12 ou 14).

8. Groupe de cartes de circuits imprimés, comprenant une carte de circuit imprimé et un boîtier entourant la carte de circuit imprimé selon la revendication 1.
